Europäisches Patentamt

European Patent Office

Office européen des brevets

(19)

(11) Veröffentlichungsnummer: **0 340 497**
**A1**

(12) **EUROPÄISCHE PATENTANMELDUNG**

(21) Anmeldenummer: **89106580.7**

(22) Anmeldetag: **13.04.89**

(51) Int. Cl.⁴: **H01L 21/82 , H01L 21/285 ,
H01L 21/90 , H01L 27/06**

(30) Priorität: **23.04.88 DE 3813836**

(43) Veröffentlichungstag der Anmeldung:
**08.11.89 Patentblatt 89/45**

(84) Benannte Vertragsstaaten:
**DE GB**

(71) Anmelder: **Licentia Patent-Verwaltungs-GmbH
Theodor-Stern-Kai 1
D-6000 Frankfurt/Main 70(DE)**

(72) Erfinder: **Kasper, Erich, Dr.
Osterholzstrasse 16
D-7914 Pfaffenhofen(DE)**
Erfinder: **König, Ulf, Dr.
Scultetusweg 2
D-7900 Ulm(DE)**
Erfinder: **Kuisl, Maximiliam, Dr.
Binsenweiherweg 9
D-7900 Ulm(DE)**
Erfinder: **Luy, Johann-Friedrich, Dr.
Schermarweg 3
D-7900 Ulm(DE)**

(74) Vertreter: **Schulze, Harald Rudolf, Dipl.-Ing.
Licentia Patent-Verwaltungs-GmbH
Theodor-Stern-Kai 1
D-6000 Frankfurt/Main 70(DE)**

(54) Verfahren zur Herstellung monolithisch integrierter, multifunktionaler Schaltungen.

(57) Die Erfindung betrifft ein Verfahren zur Herstellung monolithisch integrierter, multifunktionaler Schaltungen. Ein Schaltkreis wird im Substrat integriert und weitere mehrschichtige Halbleiterbauelemente und die entsprechenden elektrischen Zuleitungen werden auf dem Substrat übereinander angeordnet. Die mehrschichtigen Halbleiterbauelemente und die elektrischen Zuleitungen, werden aus einer epitaktisch gewachsenen Halbleiterschichtenfolge hergestellt.

EP 0 340 497 A1

## Verfahren zur Herstellung monolithisch integrierter, multifunktionaler Schaltungen

Die Erfindung betrifft ein Verfahren zur Herstellung multifunktionaler Schaltungen nach dem Oberbegriff des Patentanspruchs 1.

Die Erfindung findet Verwendung bei der Herstellung von dreidimensionalen Halbleiterschaltungen. Sie eignet sich insbesondere zum Aufbau von integrierten mm-Wellenschaltungen und Si-Mikrowellenschaltungen (Si-MMICs).

Die Herstellung von multifunktionalen Schaltungen erfolgt bisher in zweidimensionaler integrierter oder hybrider Bauweise. Das hat den Nachteil, daß Koppelverluste zwischen den einzelnen Bauteilen der Schaltung entstehen. Die Herstellung herkömmlicher hybrider und integrierter, multifunktionaler Schaltungen ist kostenintensiv, und die zweidimensionale Bauweise erfordert einen hohen Platzbedarf. Die Zuleitungen zwischen den in verschiedenen Ebenen angeordneten aktiven und/oder passiven Bauelementen bestehen aus Metallen oder Metall-Halbleiter Verbindungen.

Der Erfindung liegt daher die Aufgabe zugrunde, ein Verfahren zur Herstellung multifunktionaler Schaltungen anzugeben, bei dem durch selective Epitaxie-Verfahren dreidimensionale Schaltungsanordnungen hoher Packungsdichte und mit kurzen, verlustarmen, elektrischen Zuleitungen kostengünstig hergestellt werden.

Diese Aufgabe wird gelöst durch die im kennzeichneden Teil des Patentanspruchs 1 angegebenen Merkmale. Vorteilhafte Ausgestaltungen und/oder Weiterbildungen sind den Unteransprüchen zu entnehmen.

Bei dem erfindungsgemäßen Verfahren zur Herstellung einer multifunktionalen Schaltung ist von Vorteil, daß Halbleiterbauelemente und die für ihre Steuerung und/oder Verstärkung notwendigen integrierten Schaltkreise, sowie deren elektrische Verbindungen aus einem gemeinsamen Substrat und einer darauf aufgewachsenen Halbleiterschichtenfolge hergestellt werden. Es entsteht eine dreidimensionale Schaltungsanordnung, bei der eine hohe Packungsdichte von Halbleiterbauelementen erreicht wird. Die in verschiedenen Ebenen der dreidimensionalen Schaltung angeordneten Schaltkreise und mehr schichtigen Halbleiterbauelemente werden durch Kontaktschichten und einkristalline, vertikale Kontaktzonen elektrisch miteinander verbunden. Die Bauelementstruktur und die elektrischen Zuleitungen werden gemeinsam in einem Epitaxieverfahren hergestellt. Die elektrischen Zuleitungen bestehen zum Teil aus einkristallinem Halbleitermaterial. Es werden dadurch kurze, verlustarme, elektrische Verbindungen zwischen den einzelnen Halbleiterbauelementen gebildet.

Die Mehrschicht-Halbleiterbauelemente können unterschiedlich in die multifunktionale Schaltung integriert werden. Die Mehrschicht-Halbleiterbauelemente können

a) auf einer im Substrat vergrabenen, hochdotierten Halbleiterzone,

b) auf einem Kontaktbereich eines im Substrat befindlichen aktiven oder passiven Bauelementes,

c) auf einer elektrisch leitenden Schicht der Halbleiterschichtenfolge, die als elektrische Verbindung für die Bauelemente in verschiedenen Ebenen der dreidimensionalen Schaltung ausgebildet ist,

angeordnet werden.

Die in die Halbleiterschichtenfolge integrierten, vertikalen Kontaktzonen, die für die elektrischen Verbindungen zwischen den Bauelementen der multifunktionalen Schaltung notwendig sind, können ebenfalls auf

a) Kontaktbereichen von aktiven und passiven Bauelementen,

b) im Substrat vergrabenen, leitenden Halbleiterzonen,

c) elektrisch leitenden Schichten der Halbleiterschichtenfolge

aufgebracht werden.

Die Erfindung wird im folgenden anhand von Ausführungsbeispielen unter Bezugnahme auf schematische Zeichnungen näher erläutert.

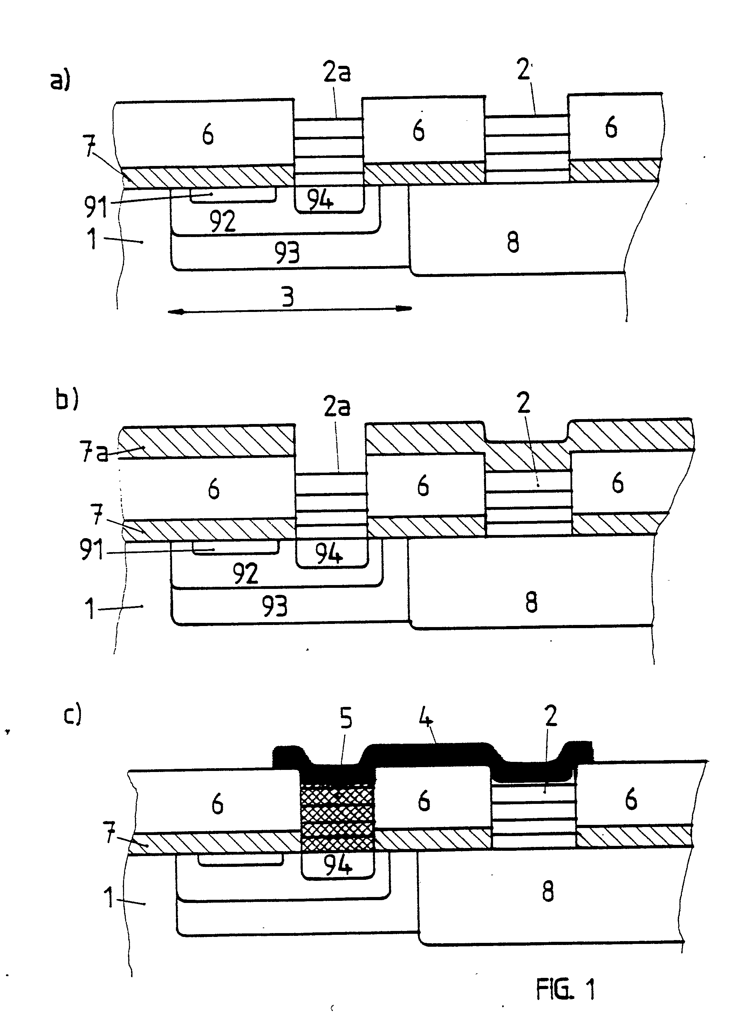

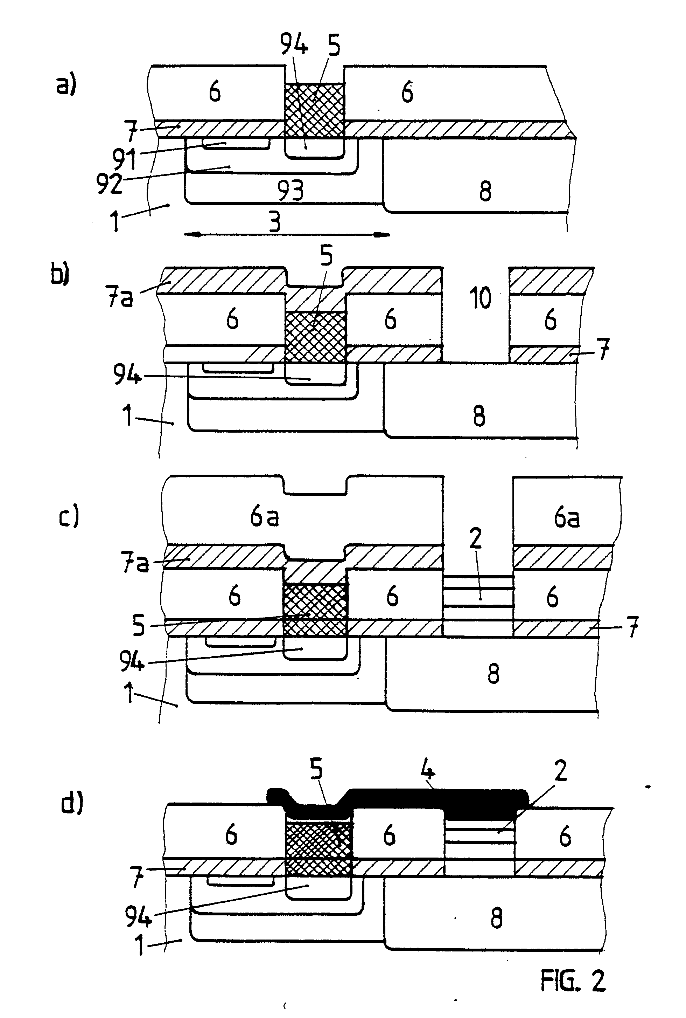

Fig. 1 und Fig. 2 zeigen die Verfahrensschritte zur Herstellung einer multifunktionalen, dreidimensionelen Schaltung.

In ein hochohmiges, einkristallines Substrat 1 aus z.B. Si wird ein Schaltkreis, der z.B. einen Bipolartransistor 3 enthält, integriert. Der Bipolartransistor 3 ist aus den in das Substrat integrierten Emitter, Basis- und Kollektorbereichen 91, 92, 94, 93 aufgebaut. Der Kollektorbereich 93 wird durch eine im Substrat 1 vergrabene, leitende Halbleiterzone 8 kontaktiert. Auf das Substrat 1 ist eine erste Passivierungsschicht 7 aus z.B. Fließglas aufgebracht, damit etwaige Strukturunebenheiten der Substratoberfläche eingeebnet werden. In der ersten Passivierungsschicht 7 werden durch bekannte Foto- und Ätzprozesse Fenster geöffnet, so daß z.B. der Basisanschluß 94 des Bipolartransistors 3 und ein Teilbereich der vergrabenen, leitenden Halbleiterzone 8 freiliegen. Mit einem Epitaxie-Verfahren, insbesondere mit der Molekularstrahlepitaxie, werden ganzflächig auf der ersten Passivierungsschicht 7 und auf dem freigelegten Basisanschluß 94, sowie auf der leitenden Halbleiterzone 8 Halbleiterschichten, beispielsweise Si-Schichten, abgeschieden. Auf dem einkristallinen Basisanschluß 94 und auf der einkristallinen, leitenden Halbleiterzone 8 entstehen einkristalline und auf der ersten Passivierungsschicht 7 polykristalline Halbleiterbereiche 2, 2a, 6 (Fig. 1a). Die Dotierung der epitaktisch gewachsenen Halbleiterschichten muß so gewählt werden, daß einerseits der polykristalline Bereich 6 hochohmig und andererseits die einkristallinen Bereiche 2, 2a elektrisch leitend sind. Auf die ein- und polykristallinen Bereiche 2, 2a, 6 wird ganzflächig eine zweite Passivierungsschicht 7 aus z.B. Fließglas aufgebracht. In der zweiten Passivierungsschicht 7a wird über dem einkristallinen Bereich 2a ein Fenster geöffnet. In den einkristallinen Bereich 2a wird z.B. As implantiert oder diffundiert (Fig. 1b). Es entsteht eine vertikale Kontaktzone 5. In vertikaler Richtung ändert sich die Leitfähigkeit der Kontaktzone 5, entsprechend den bekannten Implantations oder Diffusionsprofilen. Durch die Wahl der Implantations- oder Diffusionsdosis, der ursprünglichen Dotierung der Bauelementstruktur 2a und der geometrischen Abmessungen (Höhe und Querschnitt) der Kontaktzone ist der Widerstand der Kontaktzone einstellbar.

Anschließend wird die zweite Passivierungsschicht 7a durch naßchemisches Ätzen oder Trockenätzen abgetragen. Eine elektrisch leitende Schicht 4 aus einer Metall-Halbleiter Verbindung, z.B. NiSi$_2$, wird derart aufgewachsen, daß eine geeignete elektrische Verbindung zwischen Bauelement 2 und vertikaler Kontaktzone 5 entsteht (Fig. 1c). Durch eine Wiederholung der Prozeßfolge (Fig. 1a bis 1c) werden weitere Bauelementstrukturen und vertikale Kontaktzonen übereinander gewachsen.

Eine weitere Verfahrensvariante zur Herstellung einer dreidimensionalen, multifunktionalen Schaltung ist in den Fig. 2a bis 2d dargestellt. Analog dem oben beschriebenen Verfahren wird auf ein Substrat 1, aus z.B. einkristallinem, hochohmigen Si, das eine Bipolarschaltung mit mindestens einem Bipolartransistor 3 enthält, eine erste Passivierungsschicht 7 aus z.B. Fließglas aufgebracht. Emitter-, Basis- und Kollektorbereiche 91, 94, 92, 93 des Bipolartransistors 3 sind im Substrat 1 integriert. Der Kollektorbereich 93 wird über eine im Substrat 1 vergrabene, elektrisch leitende Halbleiterzone 8 kontaktiert. Durch bekannte Foto- und Ätzverfahren wird in der ersten Passivierungsschicht 7 über dem Basisbereich 94 des Bipolartransistors 3 ein Fenster geöffnet. Mit z.B. der Molekularstrahlepitaxie wird auf die erste Passivierungsschicht 7 und auf den Basisbereich 94 eine dicke Halbleiterschicht aus beispielsweise Si gewachsen. Auf der ersten Passivierungsschicht 7 bilden sich polykristalline Bereiche 6 und auf dem einkristallinen Basisbereich 94 wächst ein einkristalline, vertikale Kontaktzone 5 auf. Die Dotierung der vertikalen Kontaktzone 5 und der polykristallinen Bereiche 6 wird so gewählt, daß einerseits ein geeigneter Widerstand in der Kontaktzone 5 einstellbar ist und andererseits die polykristallinen Bereiche 6 hochohmig sind (Fig. 2a).

Anschließend wird ganzflächig auf die Kontaktzonen 5 und die polykristallinen Bereiche 6 eine zweite Passivierungsschicht 7a aufgebracht. In den polykristallinen Bereichen 6 wird ein Graben 10 geätzt, derart, daß die im Substrat 1 vergrabene, elektrisch leitende Halbleiterzone 8 teilweise freiliegt (Fig. 2b). Auf die zweite Passivierungsschicht 7a und in den Graben 10 werden Halbleiterschichten einer gewünschten Bauelementstruktur epitaktisch aufgewachsen. Auf der zweiten Passivierungsschicht 7a bilden sich die polykristallinen Bereiche 6a und im Graben 10 entsteht ein Mehrschicht-Bauelement 2 (Fig. 2c). Durch einen sogenannten Stripp-Prozeß durch Unterätzen der Passivierungsschicht 7a werden die polykristallinen Bereiche 6a und die Passivierungsschicht 7a entfernt. Eine elektrisch leitende Schicht 4 aus einer Metall-Halbleiterverbindung, z.B. NiSi$_2$, wird auf die poly-und einkristallinen Bereiche aufgewachsen, so daß eine elektrische Zuleitung zwischen vertikaler Kontaktzone 5 und Mehrschicht- Bauelement 2 hergestellt wird (Fig. 2d).

Durch Wiederholung der Prozeßschritte werden weitere übereinander angeordnete Mehrschicht-Bauelemente und entsprechende Kontaktzonen und elektrische Zuleitungen hergestellt. Zur Herstellung der Halbleiterschichtenfolge eignen sich sowohl die differentielle Molekularstrahlepitaxie sowie auch selektive, reaktive Epitaxieverfahren, z.B. CVD (chemical vapor deposition) oder MOVPE (metal organic vapor phase epitaxy) -Verfahren

Durch geeignete Prozeßbedingungen (z.B. Unterdruck von 50 Torr bei der MOVPE) wird erreicht, daß sich keine polykristallinen Bereiche 6a auf der zweiten Passivierungsschicht 7a bilden, und lediglich im Graben 10 einkristalline Halbleiterschichten aufwachsen.

Das erfindungsgemäße Verfahren wird zur Herstellung von dreidimensionalen, multifunktonalen Schaltungen verwendet, die z.B. in der gleichzeitig eingereichten Patentanmeldung mit dem internen Aktenzeichen UL 88/20a beschrieben sind.

Die Erfindung ist nicht auf die in den Ausführungsbeispielen angegebenen Halbleiterstrukturen und Halbleitermaterialien beschränkt. Das Substrat und die Halbleiterschichten für eine dreidimensionale Schaltung können aus unterschiedlichen Halbleitermaterialien hergestellt werden, z.B. aus Si, Ge, sowie aus III/V- und II/VI-Halbleiterverbindungen.

**Ansprüche**

1. Verfahren zur Herstellung monolithisch integrierter, multifunktionaler Schaltungen, bestehend aus mindestens einem integrierten Schaltkreis (3), der in ein einkristallines Substrat (1) integriert wird, und zumindest einem mehrschichtigen Halbleiterbauelement, dadurch gekennzeichnet,
- daß auf dem Substrat (1) eine Halbleiterschichtfolge strukturiert gewachsen wird,
- daß in der Halbleiterschichtenfolge Mehrschicht-Bauelemente (2) und entsprechende elektrische Zuleitungen enthalten sind und eine planare, dreidimensionale Schaltungsanordnung gebildet wird, und
- daß die elektrischen Zuleitungen aus epitaktisch gewachsenen, vertikalen Kontaktzonen (5) und leitenden Schichten (4) gebildet werden.

2. Verfahren nach Anspruch 1, dadurch gekennzeichnet, daß die Halbleiterschichten der Mehrschicht-Bauelemente (2) und die einkristallinen Halbleiterbereiche (2a) gleichzeitig epitaktisch gewachsen werden (Fig. 1).

3. Verfahren nach Anspruch 2, dadurch gekennzeichnet, daß die einkristallinen Halbleiterbereiche (2a) durch nachträgliche Implantations- und/oder Diffusionsverfahren als vertikale Kontaktzonen (5) eines einheitlichen Leitungstyps ausgebildet werden.

4. Verfahren nach Anspruch 1, dadurch gekennzeichnet, daß zuerst die vertikalen Kontaktzonen (5) hergestellt werden und anschließend die Halbleiterschichten für die Mehrschicht-Bauelemente (2) selektiv epitaktisch gewachsen werden (Fig. 2).

5. Verfahren nach einem der vorhergehenden Ansprüche. dadurch gekennzeichnet, daß die vertikalen Kontaktzonen (5) als nahezu widerstandslose Verbindungen zwischen den in verschiedenen Ebenen angeordneten Halbleiterbauelementen ausgebildet werden.

6. Verfahren nach einem der vorhergehenden Ansprüche 1 bis 5, dadurch gekennzeichnet, daß die vertikalen Kontaktzonen (5) als Widerstände ausgebildet werden.

7. Verfahren nach einem der vorhergehenden Ansprüche, dadurch gekennzeichnet, daß die vertikalen Kontaktzonen (5) aus einkristallinem, dotiertem Halbleitermaterial hergestellt werden.

8. Verfahren nach einem der vorhergehenden Ansprüche, dadurch gekennzeichnet, daß die elektrisch leitenden Schichten (4) aus Metall-Halbleiter-Verbindungen hergestellt werden.

FIG. 1

FIG. 2

| Europäisches Patentamt | EUROPÄISCHER RECHERCHENBERICHT | Nummer der Anmeldung |
|---|---|---|
| | | EP 89 10 6580 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 232 516 (LICENTIA PATENT-VERWALTUNGS-GmbH) * Seite 4, Zeile 9 – Seite 5, Zeile 11 * --- | 1 | H 01 L 21/82 H 01 L 21/285 H 01 L 21/90 H 01 L 27/06 |
| A | EP-A-0 263 756 (FAIRCHILD SEMICONDUCTOR CORP.) ----- | | |
| | | | **RECHERCHIERTE SACHGEBIETE (Int. Cl.4)** H 01 L |

Der vorliegende Recherchenbericht wurde für alle Patentansprüche erstellt

| Recherchenort | Abschlußdatum der Recherche | Prüfer |
|---|---|---|
| DEN HAAG | 24-07-1989 | ZOLLFRANK G.O. |